# EUROPÄISCHE PATENTSCHRIFT

(11) **EP 2 392 147 B1**
(45) Veröffentlichungstag und Bekanntmachung des Hinweises auf die Patenterteilung: **20.03.2013**
(21) Anmeldenummer: 10700167.9
(22) Anmeldetag: 11.01.2010
(51) Int. Cl.: H04R 3/00, H04R 19/01, G01R 29/12

(54) **BAUELEMENT MIT EINER MIKROMECHANISCHEN MIKROFONSTRUKTUR UND VERFAHREN ZUM BETREIBEN EINES SOLCHEN MIKROFONBAUELEMENTS**
COMPONENT COMPRISING A MICROMECHANICAL MICROPHONE STRUCTURE AND METHOD FOR OPERATING SAID MICROPHONE COMPONENT
COMPOSANT COMPRENANT UNE STRUCTURE DE MICROPHONE MICROMÉCANIQUE ET PROCÉDÉ PERMETTANT DE FAIRE FONCTIONNER UN TEL COMPOSANT

(30) Priorität: 18.02.2009 DE 102009000950; 02.02.2009 DE 102009000535
(43) Veröffentlichungstag der Anmeldung: 07.12.2011
(73) Patentinhaber: Robert Bosch GmbH, 70442 Stuttgart (DE)
(72) Erfinder: ARIAS-DRAKE, Alberto, E-41013 Sevilla (ES); BUCK, Thomas, 71732 Tamm (DE); ZOELLIN, Jochen, 70193 Stuttgart (DE); RAMOS-MARTOS, Juan, E-41009 Sevilla (ES); LAERMER, Franz, 71263 Weil Der Stadt (DE); RAGEL-MORALES, Antonio, E-41008 Sevilla (ES); CEBALLOS-CACERES, Joaquin, E-41012 Sevilla (ES); MORA-GUTIERREZ, Jose M., E-41009 Sevilla (ES)
(86) Internationale Anmeldenummer: PCT/EP2010/050208
(87) Internationale Veröffentlichungsnummer: WO 2010/086206

(56) Entgegenhaltungen:
- WO-A2-02/03747
- US-A1- 2006 008 097

## Beschreibung

### Stand der Technik

Die Erfindung betrifft ein Bauelement mit einer mikromechanischen Mikrofonstruktur. Diese umfasst mindestens eine akustisch aktive Membran, die als auslenkbare Elektrode eines Mikrofonkondensators fungiert, ein feststehendes akustisch durchlässiges Gegenelement, das als Gegenelektrode des Mikrofonkondensators fungiert, und Mittel zum Erfassen und Auswerten der Kapazitätsänderungen des Mikrofonkondensators.

Die Erfindung betrifft ferner Verfahren zum Betreiben eines solchen Mikrofonbauelements.

Kapazitive MEMS(Micro-Electro-Mechanical-System)-Mikrofone gewinnen in den unterschiedlichsten Anwendungsbereichen zunehmend an Bedeutung. Dies ist im Wesentlichen auf die miniaturisierte Bauform derartiger Bauelemente und die Möglichkeit zur Integration weiterer Funktionalitäten bei sehr geringen Herstellungskosten zurückzuführen. Besonders vorteilhaft ist die Integration von Signalverarbeitungskomponenten, wie Filtern und Komponenten zur Rauschunterdrückung sowie Komponenten zum Erzeugen eines digitalen Mikrofonsignals. Ein weiterer Vorteil von MEMS-Mikrofonen ist deren hohe Temperaturstabilität.

Die Membran der Mikrofonstruktur wird durch den Schalldruck ausgelenkt. Dadurch ändert sich der Abstand zwischen der Membran und der Gegenelektrode, was zu einer Kapazitätsänderung des Mikrofonkondensators führt. Diese sehr kleinen Kapazitätsänderungen in der Größenordnung von aF müssen in ein verwertbares elektrisches Signal umgewandelt werden.

Eine solche Mikrofonstruktur zeigt beispielsweise die US Patentanmeldung US 2006 0008097 A1.

Ein in der Praxis häufig umgesetztes Konzept beruht darauf, den Mikrofonkondensator über einen hochohmigen Ladewiderstand mit einer Gleichspannung aufzuladen. Kapazitätsänderungen des Mikrofonkondensators werden dann als Schwankungen der Ausgangsspannung erfasst, die über einen Impedanzkonverter verstärkt wird. Dabei kann es sich beispielsweise um einen JFET handeln, der den hohen Widerstand des Mikrofons in der Größenordnung von GOhm in einen relativ niedrigen Ausgangswiderstand in der Größenordnung von einigen 100 Ohm umwandelt, ohne die Ausgangsspannung selbst zu verändern. Anstelle eines JFET kann auch eine Operationsverstärkerschaltung verwendet werden, die einen niedrigen Ausgangswiderstand liefert. Im Unterschied zum JFET kann hier der Verstärkungsfaktor an die jeweiligen Mikrofonerfordernisse angepasst werden.

Das bekannte Konzept erweist sich in mehrerlei Hinsicht als problematisch:
So lassen sich die digitalen Schaltungselemente nicht ohne Weiteres zusammen mit den analogen Signalverarbeitungskomponenten in CMOS-Technologie realisieren, da dabei Elektrorauschen auftritt. Die erforderliche rauscharme JFET-Technologie kann im Rahmen von Standard CMOS-Prozessen nicht realisiert werden.

Aufgrund der am Mikrofonkondensator anliegenden Gleichspannung herrschen während des Mikrofonbetriebs elektrostatische Anziehungskräfte zwischen der Membran und der Gegenelektrode. Diese sind insbesondere in Überlastsituationen kritisch, da sie ein dauerhaftes Anhaften der Membran an der Gegenelektrode begünstigen, was zu einem Zusammenbruch der Mikrofonfunktion führt. Zum Lösen der Membran von der Gegenelektrode muss der Mikrofonkondensator in der Regel vollständig entladen werden. In der Praxis versucht man mit mechanischen Maßnahmen, wie z.B. einer relativ steifen Membranaufhängung, einem relativ großen Abstand zwischen Membran und Gegenelektrode oder mechanischen Anschlägen, einen derartigen elektrostatischen Kollaps zu vermeiden. Diese Maßnahmen wirken sich jedoch meist nachteilig auf die Empfindlichkeit des Mikrofons aus oder sind herstellungstechnisch sehr aufwendig.

Schließlich sei noch erwähnt, dass eine relativ hohe Gleichspannung in der Größenordnung von 10 Volt und mehr an den Mikrofonkondensator angelegt werden muss, um einen hinreichend hohen SNR(signal-to-noise-ratio) zu erzielen. Eine Ladespannung dieser Größenordnung erfordert aber einen vergleichsweise großen Abstand zwischen der Membran und der Gegenelektrode in der Größenordnung von >>2µm, um einerseits einen elektrostatischen Kollaps zu vermeiden und andererseits einen hinreichend großen Auslenkungsbereich für die Membran zur Verfügung zu stellen. Derartig große Abstände lassen sich nicht ohne Weiteres mit Standardverfahren der Oberflächenmikromechanik herstellen. Außerdem kommt es bei derart hohen Ladespannungen in Überlastsituationen nicht nur zu einem Anhaften der Membran an der Gegenelektrode sondern zu einem irreversiblen Verschmelzen der Kontaktoberflächen. In der Praxis versucht man, dies mit Hilfe von Isolationsschichten zu verhindern. Diese erhöhen jedoch die Komplexität des Herstellungsverfahrens und damit letztlich die Kosten für ein derartiges Mikrofonbauelement.

### Offenbarung der Erfindung

Mit der vorliegenden Erfindung wird ein Konzept für ein MEMS-Mikrofon vorgeschlagen, das auf einem relativ niedrigen Spannungsniveau betrieben werden kann und dennoch eine vergleichsweise hohe Empfindlichkeit aufweist. Zudem kann ein solches MEMS-Mikrofon äußerst kostengünstig hergestellt werden.

Das erfindungsgemäße Konzept sieht vor, ein hochfrequentes Taktsignal an den Mikrofonkondensator anzulegen und das invertierte Taktsignal an einen einstellbaren aber akustisch nicht aktiven Kompensationskondensator anzulegen. Mit Hilfe eines integrierenden Operationsverstärkers wird die Summe des Stromflusses durch den Mikrofonkondensator und des Stromflusses durch den Kompensationskondensator aufintegriert. Das Ausgangssignal des integrierenden Operationsverstärkers wird dann mit Hilfe eines mit dem Taktsignal synchronisierten Demodulators demoduliert. Durch eine Tiefpassfilterung des demodulierten Signals wird schließlich ein den Kapazitätsänderungen des Mikrofonkondensators entsprechendes Mikrofonsignal gewonnen.
Dementsprechend umfasst das erfindungsgemäße Mikrofonbauelement Mittel zum Anlegen eines hochfrequenten Taktsignals an den Mikrofonkondensator und zum Anlegen des invertierten Taktsignals an einen einstellbaren aber akustisch nicht aktiven Kompensationskondensator, ferner einen integrierenden Operationsverstärker, der die Summe des Stromflusses durch den Mikrofonkondensator und des Stromflusses durch den Kompensationskondensator aufintegriert, einen mit dem Taktsignal synchronisierten Demodulator für das Ausgangssignal des integrierenden Operationsverstärkers und einen Tiefpassfilter, um aus dem Ausgangssignal des Demodulators ein den Kapazitätsänderungen des Mikrofonkondensators entsprechendes Mikrofonsignal zu gewinnen.

Der einstellbare Kompensationskondensator dient der Kompensation des Gleichstromanteils, der durch den Mikrofonkondensator fließt und nicht auf Schalleinwirkungen zurückzuführen ist, sondern fertigungsbedingt oder beispielsweise auch aufgrund eines Driftverhaltens des Mikrofonkondensators auftritt. Idealerweise wird der Kompensationskondensator entsprechend der Ruhekapazität des Mikrofonkondensators eingestellt. Da am Kompensationskondensator das invertierte Taktsignal anliegt, während der Mikrofonkondensator mit dem Taktsignal gespeist wird, integriert der Operationsverstärker nur den Anteil des Stromflusses durch den Mikrofonkondensator auf, der auf die schallbedingten Kapazitätsänderungen des Mikrofonkondensators zurückzuführen ist. Aus dem Ausgangssignal des integrierenden Operationsverstärkers lässt sich dann relativ einfach ein diese Kapazitätsänderungen wiedergebendes Mikrofonsignal gewinnen, nämlich durch synchronisierte Demodulation und Tiefpassfilterung.

Die erfindungsgemäße Art der Signalerfassung liefert bereits bei einem Spannungsniveau des hochfrequenten Taktsignals von unter 2 Volt eine akzeptable Empfindlichkeit bzw. einen hinreichend hohen SNR. Dies ist insbesondere auch in Überlastsituationen von Vorteil. Bei Spannungen dieser Größenordnung führt nämlich eine Berührung zwischen der Membran und der Gegenelektrode nicht zum Verschmelzen der Kontaktoberflächen und damit auch nicht zur Zerstörung der Mikrofonstruktur. Deshalb kann im Rahmen des erfindungsgemäßen Konzepts auf einen mechanischen Überlastschutz in Form von elektrisch isolierenden Anschlägen verzichtet werden.
Sowohl die mikromechanische Struktur des erfindungsgemäßen Bauelements als auch dessen schaltungstechnische Komponenten zur Signalerfassung lassen sich mit Standardprozessen der CMOS-Technologie und damit sehr kostengünstig erzeugen.

In einer besonders vorteilhaften Ausführungsform der Erfindung wird der Kompensationskondensator automatisch an die Ruhekapazität des Mikrofonkondensators angepasst. Dieser Regelung wird der Gleichspannungsanteil des Demodulator-Ausgangssignals zugrundegelegt, da dieser Gleichspannungsanteil der Asymmetrie zwischen Mikrofon- und Kompensationskondensator entspricht. Der Gleichspannungsanteil lässt sich sehr einfach mit Hilfe eines dem Demodulator nachgeschalteten Offset-Filters ermitteln. Um sicher zugehen, dass tatsächlich nur der Gleichspannungsanteil herausgefiltert wird, sollte die obere Grenzfrequenz dieses Offset- Filters deutlich unter der unteren Grenzfrequenz des Mikrofons liegen. Der Kompensationskondensator wird nun einfach so eingestellt, dass der Gleichspannungsanteil des Demodulator-Ausgangssignals minimiert wird.

Dazu kann der einstellbare Kompensationskondensator beispielsweise in Form einer schaltbaren Kondensatorbank realisiert sein. Diese kann eine binäre Verteilung von Kapazitätswerten und/oder eine Reihe von gleichen Kapazitätswerten umfassen, die wahlweise zusammengeschaltet werden. Anstelle der Variation des Kompensationskondensators kann auch die Weselspannungsamplitude des invertierten Taktsignals am Kompensationskondensator über eine Widerstandsreihe bzw. einen Spannungsteiler eingestellt werden. Eine Variation des Spannungspegels wirkt sich durch Änderung des Stroms durch den Kompensationskondensator äquivalent zu einer Änderung des Kondensatorwertes aus. Da sich das Zuschalten von sehr kleinen Kapazitätswerten in der Größenordnung von Femto-Farad als schwer kontrollierbar erweisen kann, ist eine Kombination beider Verfahren sehr vorteilhaft. Dabei wird die Grobeinstellung durch geschaltete Kondensatoren erreicht und die Feineinstellung durch geringfügige Variation des Spannungspegels.

Vorteilhafterweise erfolgt die Anpassung des Kompensationskondensator schrittweise, um der Dynamik des Systems Rechnung zu tragen. Je nach Art der verwendeten Kondensatorbank und/oder Widerstandsreihe können unterschiedliche Annäherungsstrategien angewandt werden. Bei einer Kondensator- oder Widerstandsbank mit einer Reihe von gleichen Kapazitäts- bzw. Widerstandswerten bietet sich eine lineare Annäherung an. Ein binärer Suchalgorithmus lässt sich einfacher mit einer Kondensatorbank realisieren, deren Kapazitätswerte binär verteilt sind.

Sinnvollerweise wird der Kompensationskondensator zusammen mit dem Mikrofonbauelement initialisiert. In diesem Fall erfolgt die automatische Anpassung des Kompensationskondensators also vor dem eigentlichen Mikrofonbetrieb während der Initialisierung bzw. während des Abgleichs des Mikrofonbauelements.

In einer besonders vorteilhaften Weiterbildung der Erfindung wird der Gleichspannungs-Offset des Ausgangssignals des Demodulators aber nicht nur während dieser Initialisierungsphase erfasst, sondern auch während des eigentlichen Mikrofonbetriebs, um die Funktionsfähigkeit des Mikrofons zu überwachen und um Überlastsituationen, insbesondere einen elektrostatischen Kollaps der Elektroden des Mikrofonkondensators, frühzeitig zu erkennen und geeignete Gegenmaßnahmen zu treffen.

Tritt im Falle einer Überlastsituation ein Berührungskontakt zwischen der beweglichen Membran und der feststehenden Gegenelektrode auf, so wird der Mikrofonkondensator elektrisch kurzgeschlossen. In diesem Moment steigt der Gleichspannungsanteil sehr schnell sehr stark an, bevor die Mikrofonfunktion vollständig zusammenbricht, da die Membran aufgrund der elektrostatischen Verhältnisse in der Regel an der Gegenelektrode haften bleibt. Eine derartige Überlastsituation wird in einer vorteilhaften Ausführungsform der Erfindung anhand des peakartigen Verlaufs des Gleichspannungs-Offset-Signals detektiert. Dazu wird der Gleichspannungsanteil regelmäßig mit einem vorgegebenen maximalen Grenzwert verglichen. Übersteigt der Gleichspannungsanteil diesen maximalen Grenzwert, so wird automatisch ein elektrischer Reset vorgenommen, bei dem der Mikrofonkondensator entladen wird, um die Membran von der Gegenelektrode zu lösen und die Mikrofonfunktion wieder herzustellen. Bei dieser Variante der Erfindung wird also rein schaltungstechnisch eine Art Überlastschutz für das Mikrofonbauelement realisiert. Auf entsprechende mechanische Maßnahmen kann hier verzichtet werden, was das Herstellungsverfahren für das erfindungsgemäße Bauelement insgesamt deutlich vereinfacht.

Die Überwachung des Gleichspannungsanteils kann außerdem dazu genutzt werden, die Einstellung des Kompensationskondensators während des Mirofonbetriebs nachzuregeln, beispielsweise um Langzeitdrift-Erscheinungen entgegenzuwirken. Dazu wird in einer vorteilhaften Weiterbildung der Erfindung auch während des Mikrofonbetriebs eine automatische Anpassung des Kompensationskondensators vorgenommen, und zwar immer dann, wenn der Gleichspannungs-Offset ein durch einen weiteren Grenzwert vorgegebenes Toleranzband verlässt. Dieser zweite Grenzwert wird deutlich kleiner gewählt, als der maximale Grenzwert, der den elektrostatischen Kollaps kennzeichnet. Dies wird nachfolgend anhand eines Ausführungsbeispiels der Erfindung noch näher erläutert.

In einer besonders vorteilhaften Weiterbildung der Erfindung wird der Gleichspannungsanteil des demodulierten Signals nicht nur zur Anpassung des Kompensationskondensators und/oder zur Überwachung der Mikrofonfunktion genutzt, sondern auch zur Detektion von auf das Mikrofonbauelement wirkenden Beschleunigungen. Dabei wird ausgenutzt, dass grundsätzlich jede kapazitive Mikrofonstruktur auch gegenüber Beschleunigungen, wie z.B. der Erdbeschleunigung, empfindlich ist. Wirkt eine Beschleunigung senkrecht auf die Mikrofonmembran ein, so wird diese aufgrund ihrer Masse und flexiblen Aufhängung ausgelenkt, was zu einer entsprechenden Kapazitätsänderung führt. Dabei handelt es sich in der Regel um statische oder zumindest sehr niederfrequente Kapazitätsänderungen, die sich im Signalverlauf des Gleichspannungsanteils wiederspiegeln. Das erfindungsgemäße Konzept ermöglicht also bei entsprechender Auswertung des Signalverlaufs des Gleichspannungsanteils die Detektion von senkrecht zur Mikrofonmembran wirkenden Beschleunigungen, ohne dass dazu ein zusätzliches Sensorelement erforderlich ist. Mit diesem Konzept lässt sich demnach nicht nur ein sehr kostengünstiges Mikrofon mit vergleichsweise hoher Empfindlichkeit und Robustheit realisieren, es bietet außerdem noch die Möglichkeit, Bewegungen oder einfach nur Lageänderungen des Einbaugeräts ohne zusätzliche Sensorelemente zu detektieren. Das erfindungsgemäße Bauelement könnte beispielsweise im Rahmen eines Telefons oder PDAs eingesetzt werden, um zu erkennen, ob das Gerät bewegt wird oder ruhig auf dem Tisch liegt, und dann automatisch zwischen Vibrationsalarm und Klingeln umzuschalten. Im Fall einer Telefonanwendung könnten einzelne Bedienaktionen, wie z.B. eine Tastensperre an- bzw. ausschalten oder einen eingehenden Anruf annehmen bzw. abweisen, durch einfache Gesten initiiert werden, wie z.B. durch Rotation des Geräts um eine bestimmte Achse.

Wie bereits erwähnt, werden die Beschleunigungsinformationen aus dem Gleichspannungsanteil des demodulierten Signals ermittelt. Dieser Gleichspannungsanteil kann durch eine entsprechende Tiefpassfilterung des Ausgangssignals des Demodulators gewonnen werden, er kann aber auch mit Hilfe eines einfachen Tiefpassfilters vom Mikrofonsignal abgetrennt werden, während ein optionaler Hochpass das Verhalten klassischer Mikrofone am Ausgang nachbildet. Ein solcher Hochpass ist optional, weil in typischen Schaltungen für Mikrofone ohnehin schon ein Hochpass zur kapazitiven Entkopplung enthalten ist. Die technische Realisierung eines geeigneten Tiefpassfilters kann an verschiedenen Stellen erfolgen. Er kann beispielsweise in den ASIC integriert sein, so dass sich die Beschleunigung über ein weiteres Pin abgreifen lässt. Eine andere Möglichkeit besteht darin, den Tiefpassfilter auf der Trägerleiterplatte in Form von diskreten Bauteilen zu realisieren. Des Weiteren kann der Tiefpassfilter auch in den Signalverarbeitungsschaltkreis integriert sein, z.B. in den Chipsatz eines Mobiltelefons. Im Falle eines digitalen Mikrofonsignals kann der Tiefpassfilter schließlich auch als reine Softwarelösung realisiert werden, was besonders attraktiv ist, da hier keinerlei zusätzliche Bauteile oder Schaltungsänderungen notwendig sind.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche verwiesen und andererseits auf die nachfolgende Beschreibung eines Ausführungsbeispiels der Erfindung anhand der Figuren.
- Fig. 1: zeigt ein schematisches Schaltbild eines erfindungsgemäßen Bauelements,
- Fig. 2: zeigt ein Blockschaltbild der Funktionalität eines erfindungsgemäßen Bauelements,
- Fig. 3: zeigt den zeitlichen Verlauf des Gleichspannungs-Offset-Signals während der Initialisierung eines erfindungsgemäßen Bauelements und während des anschließenden Mikrofonbetriebs,
- Fig. 4a, b: zeigen jeweils eine Realisierungsmöglichkeit für den Kompensationskondensator eines erfindungsgemäßen Bauelements und
- Fig. 5: zeigt den zeitlichen Verlauf des Gleichspannungs-Offset-Signals für den Fall einer binären Anpassung des Kompensationskondensators.

### Ausführungsformen der Erfindung

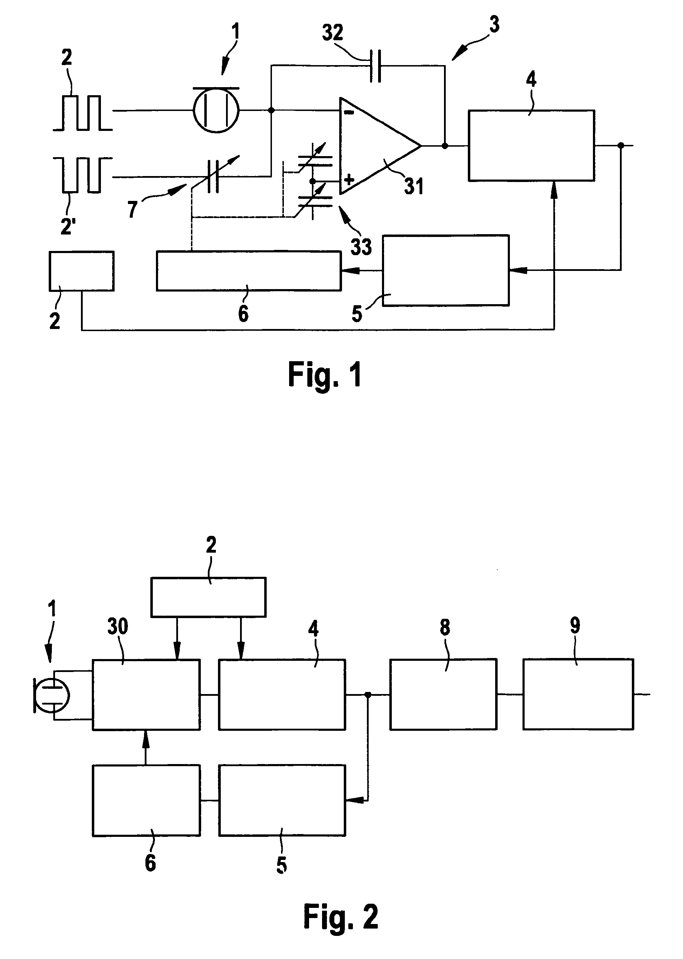

Ein Hauptbestandteil des erfindungsgemäßen Bauelements ist eine mikromechanische Mikrofonstruktur, die eine akustisch aktive Membran und ein feststehendes akustisch durchlässiges Gegenelement umfasst. Die Membran und das Gegenelement bilden die auslenkbare und die feststehende Elektrode eines Mikrofonkondensators, der in Fig. 1 mit 1 bezeichnet ist. Bei Schalleinwirkung ändert sich der Abstand zwischen der Membran und der Gegenelektrode und damit auch die Kapazität des Mikrofonkondensators 1. Zum Erfassen dieser Kapazitätsänderungen wird der Mikrofonkondensator 1 mit einem hochfrequenten Taktsignal 2 beaufschlagt. Der resultierende Stromfluss durch den Mikrofonkondensator 1 wird dem Minus-Eingang eines Ladungsverstärkers 31 zugeführt.

Neben dem akustisch aktiven Mikrofonkondensator 1 umfasst das erfindungsgemäße Bauelement noch einen akustisch nicht aktiven einstellbaren Kompensationskondensator 7. Mit diesem soll der Strom kompensiert werden, der während der Beaufschlagung mit dem hochfrequenten Taktsignal durch den Mikrofonkondensator 1 fließt. Dazu wird der einstellbare Kompensationskondensator 7 mit dem invertierten Taktsignal 2' gespeist. Der resultierende Stromfluss durch den Kompensationskondensator 7 wird ebenfalls dem Minus-Eingang des Ladungsverstärkers 31 zugeführt.

Da der Ausgang des Ladungsverstärkers 31 über einen Kondensator 32 auf den Minus-Eingang rückgekoppelt ist, bildet der Operationsverstärker 31 zusammen mit dem Kondensator 32 einen integrierenden Ladungsverstärker 3, der die Summe der Stromflüsse durch die beiden Kondensatoren 1 und 7 aufintegriert. Idealerweise wird der Kompensationskondensator 7 so eingestellt, dass dessen Kapazität der Ruhekapazität des Mikrofonkondensators 1 entspricht. In diesem Fall heben sich die beiden Stromflüsse weitestgehend auf, bis auf die Abweichungen, die auf die schallbedingten Kapazitätsschwankungen des Mikrofonkondensators 1 zurückzuführen sind. Nur diese werden dann mit Hilfe des integrierenden Operationsverstärkers 3 aufintegriert.

Um aus dem Ausgangssignal des integrierenden Operationsverstärkers 3 ein Mikrofonsignal zu gewinnen, das die schallbedingten Kapazitätsschwankungen des Mikrofonkondensators 1 wiedergibt, wird dieses Ausgangssignal einem Demodulator 4 zugeführt, der mit dem Taktsignal 2 synchronisiert ist. Aus dem demodulierten Signal kann dann durch geeignete Tiefpassfilterung ein analoges Mikrofonsignal gewonnen werden. Beispielsweise durch zusätzliche Anwendung einer Sigma-Delta-Umwandlung kann alternativ auch ein digitales Mikrofonsignal gewonnen werden.

Der Kompensationskondensator 7 wird bei dem hier beschriebenen Ausführungsbeispiel automatisch eingestellt, und zwar während der Initialisierungs- bzw. Abgleichsphase des Mikrofonbauelements. Dazu wird das Ausgangssignal des Demodulators 4 einem Tiefpassfilter 5 zugeführt, dessen obere Grenzfrequenz deutlich unter der unteren Grenzfrequenz des Mikrofons liegen sollte. Mit Hilfe dieses Tiefpassfilters 5 wird der Gleichspannungsanteil des demodulierten Signals ermittelt und damit letztlich die Asymmetrie zwischen Mikrofonkondensator 1 und Kompensationskondensator 7. Der Kompensationskondensator 7 wird nun mit Hilfe einer Regelungsstufe 6 automatisch so verändert, dass der Gleichspannungsanteil minimiert wird.
An dieser Stelle sei angemerkt, dass das Gleichspannungs-Offset-Signal nicht unbedingt direkt aus dem Ausgangssignal des Demodulators 4 gewonnen werden muss sondern auch aus dem Ausgangssignal einer nachfolgenden Verarbeitungsstufe gewonnen werden kann, solange der Gleichspannungsanteil noch nicht herausgefiltert worden ist.

Im hier dargestellten Ausführungsbeispiel ist dem Referenzeingang des Ladungsverstärkers 31 eine Referenzkondensatoranordnung 33 vorgeschaltet, die ebenfalls mit Hilfe der Regelstufe 6, also auf der Grundlage des überwachten Gleichspannungs-Offset-Signals, geregelt wird, um eine möglichst gute Rausch- und Störsignalunterdrückung gegenüber der Versorgungsspannung zu erzielen.

Das Blockschaltbild der Fig. 2 veranschaulicht nochmals die Funktionalität und das Zusammenwirken der einzelnen Komponenten eines erfindungsgemäßen Bauelements, wobei hier nur der Mikrofonkondensator 1 als Aufnehmer des akustischen Signals und Umwandler in ein elektrisches Signal gesondert dargestellt ist. Der einstellbare aber akustisch nicht aktive Kompensationskondensator ist hier Teil der Verstärkerkomponente 30 und daher nicht gesondert dargestellt. Das hochfrequente Taktsignal 2 liegt über den Mikrofonkondensator und in invertierter Form auch über den Kompensationskondensator an der Verstärkerkomponente 30 an. Außerdem wird das Taktsignal 2 zur Synchronisierung des der Verstärkerkomponente 30 nachgeschalteten Demodulators 4 gebraucht.
Bei der in Fig. 2 dargestellten Variante wird das demodulierte Signal zunächst einem Verstärker 8 zugeführt. In einer weiteren Verarbeitungsstufe 9 erfolgt dann eine Tiefpassfilterung und eine optionale Sigma-Delta-Umwandlung, um aus dem demodulierten Signal ein digitales Mikrofonsignal zu gewinnen, das die schallbedingten Kapazitätsänderungen des Mikrofonkondensators 1 wiedergibt.

Wie im Fall der Fig. 1 wird das Ausgangssignal des Demodulators 4 außerdem einer Tiefpassfilter-Komponente 5 zugeführt, um den Gleichspannungsanteil des demodulierten Signals zu ermitteln und der Anpassung des Kompensationskondensators zugrunde zu legen. Diese Regelung erfolgt in der Regelungsstufe 6.

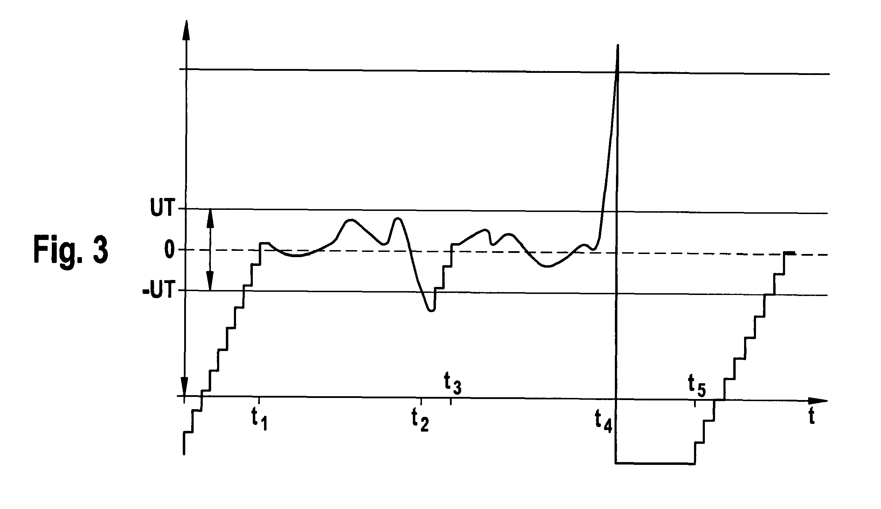

Die Anpassung und Regelung des Kompensationskondensators sowie die Überwachung der Mikrofonfunktion eines erfindungsgemäßen Bauelements wird nachfolgend in Verbindung mit dem in Fig. 3 dargestellten zeitlichen Verlauf des Gleichspannungs-Offset-Signals UOffset erläutert.

Im hier beschriebenen Ausführungsbeispiel wird der Kompensationskondensator des erfindungsgemäßen Bauelements ein erstes Mal während der Initialisierung des Bauelements eingestellt. Dies erfolgt schrittweise, wobei die Ruhekapazität des Mikrofonkondensators linear angenähert wird. Dazu wird der Gleichspannungsanteil des Ausgangssignals des Demodulators kontinuierlich oder zumindest regelmäßig überwacht und durch entsprechende Veränderung der Kapazität des Kompensationskondensators sukzessive minimiert. Diese Vorgehensweise hat den stufigen Signalverlauf bis zum Zeitpunkt t1 zur Folge. Zum Zeitpunkt t1 ist die Initialisierungsphase des Mikrofonbauelements und auch die Ersteinstellung des Kompensationskondensators abgeschlossen.

Ab dem Zeitpunkt t1 wird der Gleichspannungsanteil zur Überwachung der Mikrofonfunktion des Bauelements genutzt. Solange sich der Gleichspannungsanteil innerhalb eines durch den Grenzwert UT vorgegebenen Toleranzbandes um die Nulllinie bewegt, wie im Zeitraum zwischen t1 und t2, erfüllt die Mikrofonfunktion die angestrebten Qualitätskriterien. Im hier beschriebenen Ausführungsbeispiel deckt das Toleranzband ca. 10% des Spannungsbereichs des demodulierten Signals ab. Selbstverständlich können die Lage und Breite dieses Toleranzbandes auch anders gewählt werden, wobei in erster Linie die Mikrofon- und Schaltungscharakteristiken zu berücksichtigen sind.
Zum Zeitpunkt t2 wandert das Gleichspannungs-Offset-Signal aus dem Toleranzband heraus, indem der Gleichspannungs-Offset den unteren Grenzwert - UT unterschreitet. Dies löst eine automatische Nachregelung des Kompensationskondensators aus. Die Kapazität des Kompensationskondensators wird jetzt so verändert, dass sich der Gleichspannungs-Offset wieder innerhalb des vorgegebenen Toleranzbandes bewegt. Diese zweite Anpassung erfolgt ebenfalls in gleichmäßigen Schritten, was sich in dem stufigen Signalverlauf zwischen t2 und t3 wiederspiegelt.

Zum Zeitpunkt t4 steigt der Gleichspannungs-Offset peakartig an und übersteigt dabei nicht nur den Grenzwert UT sondern in rascher Folge auch einen vorgegebenen maximalen Grenzwert Umax. Im hier beschriebenen Ausführungsbeispiel definiert der maximale Grenzwert Umax einen Spannungsbereich um der Nulllinie, der ca. 30% des Spannungsbereichs des demodulierten Signals abdeckt. Auch der maximale Spannungsbereich kann je nach Art der Anwendung und Bauteilcharakteristik anders gewählt werden.
Dieser peakartige Signalverlauf wird als elektrostatischer Kollaps des Mikrofonkondensators interpretiert, bei dem die Membran und die Gegenelektrode in Berührungskontakt treten, also kurzgeschlossen werden, und aneinander haften bleiben. In diesem Fall wird ein elektrischer Reset initiiert, bei dem der Mikrofonkondensator entladen wird, um die Membran von der Gegenelektrode zu lösen. Dazu kann beispielsweise eine eigene Schalteranordnung vorgesehen sein. Erst nach einer gewissen Wartezeit, zum Zeitpunkt t5, wird die Mikrofonfunktion wiederaufgenommen. Dann erfolgt auch eine erneute Anpassung des Kompensationskondensators, um den Gleichspannungs-Offset wieder zu minimieren und innerhalb des vorgegebenen Toleranzbandes zu halten.

Der in Fig. 3 dargestellte Verlauf des Gleichspannungs-Offset-Signals zeigt also, dass der Kompensationskondensator während der Anlauf-Phase des Mikrofons einmalig so eingestellt wird, dass der Gleichspannungs-Offset minimiert wird. Während des Mikrofonbetriebs bewegt sich der Gleichspannungs-Offset dann innerhalb eines vorgegebenen Toleranzbandes, das den Normalbetrieb des Mikrofons kennzeichnet. Dies wird beispielsweise mit Hilfe von Komparatoren kontinuierlich oder auch nur regelmäßig weiter überwacht. Solange sich der Gleichspannungs-Offset innerhalb des vorgegebenen Toleranzbandes bewegt, werden keine korrigierenden Maßnahmen zur Beeinflussung der Mikrofonfunktion getroffen. Nur in seltenen Fällen, beispielsweise aufgrund von Langzeitdrifterscheinungen, bewegt sich der Gleichspannungs-Offset langsam aus dem Toleranzband heraus. Dann wird der Kompensationskondensator automatisch nachgeregelt, um den Gleichspannungs-Offset wieder zu minimieren bzw. auf das vorgegebene Toleranzband zu begrenzen. In Überlastsituationen, die einen Ausfall der Mikrofonfunktion zur Folge haben, ändert sich der Gleichspannungs-Offset sprunghaft und überschreitet dabei einen vorgegebenen maximalen Grenzwert, der deutlich außerhalb des Toleranzbandes liegt. In solchen Fällen wird ein Reset durchgeführt, bei dem der Mikrofonkondensator vollständig entladen wird. Der Mikrofonbetrieb wird dann erst nach einer bestimmten Wartezeit wieder aufgenommen, wenn sichergestellt ist, dass sich die Membran wieder von der Gegenelektrode des Mikrofonkondensators gelöst hat. Dann wird auch der Kompensationskondensator wie in der ersten Anlauf-Phase des Mikrofons eingestellt, um den Gleichspannungs-Offset zu minimieren.

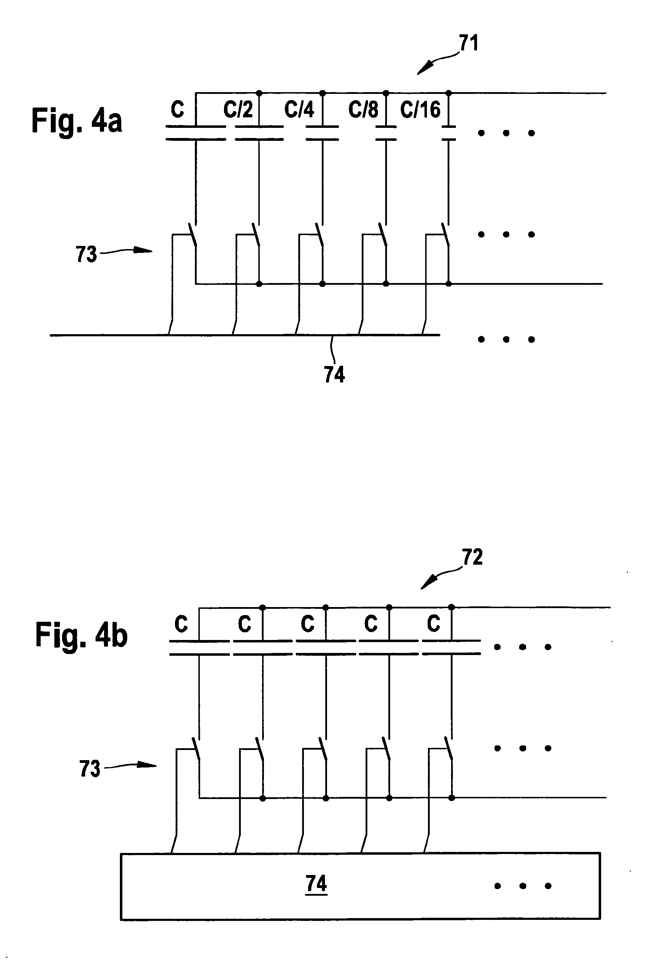

In den Figuren 4a und 4b sind zwei Realisierungsmöglichkeiten für einen einstellbaren Kompensationskondensator dargestellt. In beiden Fällen handelt es sich um eine schaltbare Kondensatorbank. Während die Kondensatorbank 71 der **Fig. 4a** eine binäre Verteilung von Kapazitätswerten, nämlich C, C/2, C/4, ..., umfasst, die über analoge Schalter 73 wahlweise zuschaltbar sind, besteht die Kondensatorbank 72 der Fig. 4b aus einer Reihe von gleichen Kapazitäten, die ebenfalls wahlweise zuschaltbar sind. In beiden Fällen werden die analogen Schalter über einen binären Decoder 74 angesteuert.

Wie bereits erwähnt, erfolgt die Anpassung des Kompensationskondensator meist schrittweise.

Im Fall eines linearen Näherungsverfahrens, wie es im Fall der Fig. 3 angewendet wurde, startet die Iteration bei einem vorgegebenen Kapazitätswert, der einem bestimmten digitalen Zählerstand des binären Decoders entspricht. Dabei kann es sich entweder um die größt mögliche oder auch um die kleinste realisierbare Kapazität der Kompensationskondensatoranordnung handeln. Es kann aber beispielsweise auch ein Kapazitätswert dazwischen gewählt werden, der auf einer Schätzung beruht. Je nach dem, ob sich der Gleichspannungs-Offset aufgrund der getätigten Einstellung des Kompensationskondensators vergrößert oder verkleinert hat, wird der Zählerstand des binären Decoders um Eins erhöht oder um Eins erniedrigt, was eine entsprechende Kapazitätserhöhung oderverringerung zur Folge hat. Diese Prozedur wird solange wiederholt, bis der Gleichspannungs-Offset minimal ist oder sich zumindest innerhalb des vorgegebenen Toleranzbandes bewegt. In diesem Fall werden bis zu 128 Iterationsschritte für einen 7-bit Decoder benötigt.

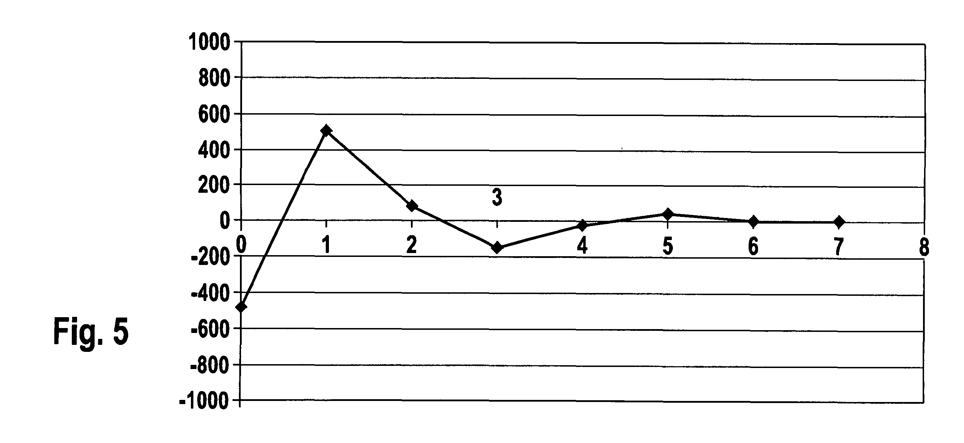

Fig. 5 veranschaulicht ein binäres Näherungsverfahren zur Anpassung des Kompensationskondensators. In diesem Fall erfolgt die Iteration anhand des Decoder Kontroll-Worts bit-weise. Im hier beschriebenen Ausführungsbeispiel werden zu Beginn der Iteration alle bit des Kontroll-Worts auf Null gesetzt, was der kleinsten mit der Kompensationskondensatoranordnung realisierbaren Kapazität entspricht. Diese Kapazität wird nun durch Setzen des ersten bits erhöht. Danach wird der Gleichspannungs-Offset mit der Nulllinie verglichen, um zu entscheiden, ob die zugeschaltete Kapazität zu groß oder nicht groß genug war, um eine optimale Anpassung zu erzielen. Falls die Kapazität zu groß war, wird sie wieder abgeschaltet und das entsprechende bit wird wieder auf Null gesetzt. Ansonsten wird die zugeschaltete Kapazität beibehalten. Ebenso wird mit den nachfolgenden bit des Decoder Kontroll-Worts verfahren. Fig. 5 zeigt den Verlauf des Gleichspannungs-Offsets für die ersten sieben bit des Decoder Kontroll-Worts, was 7 Iterationsschritten entspricht. Der hier beschriebene Algorithmus ist sehr stabil gegen Asymmetrien, die typischerweise bei Kapazitäten in integrierten Schaltkreisen auftreten. Zudem benötigt eine binäre Approximation im Vergleich zu einer linearen Approximation eine geringere Anzahl an Iterationsschritten, während aber ein größerer Kapazitätsbereich abgedeckt wird.

## Patentansprüche

1. Bauelement mit einer mikromechanischen Mikrofonstruktur, mindestens umfassend
- eine akustisch aktive Membran, die als auslenkbare Elektrode eines Mikrofonkondensators (1) fungiert,
- ein feststehendes akustisch durchlässiges Gegenelement, das als Gegenelektrode des Mikrofonkondensators (1) fungiert, und
- Mittel zum Erfassen und Auswerten der Kapazitätsänderungen des Mikrofonkondensators (1);
**gekennzeichnet durch**
- Mittel zum Anlegen eines hochfrequenten Taktsignals (2) an den Mikrofonkondensator (1) und zum Anlegen des invertierten Taktsignals (2') an einen einstellbaren aber akustisch nicht aktiven Kompensationskondensator (7),
- einen integrierenden Operationsverstärker (3), der die Summe des Stromflusses **durch** den Mikrofonkondensator (1) und des Stromflusses **durch** den Kompensationskondensator (7) aufintegriert,
- einen mit dem Taktsignal (2) synchronisierten Demodulator (4) für das Ausgangssignal des integrierenden Operationsverstärkers (3) und
- einen Tiefpassfilter, um aus dem Ausgangssignal des Demodulators (4) ein den Kapazitätsänderungen des Mikrofonkondensators (1) entsprechendes Mikrofonsignal zu gewinnen.

2. Bauelement nach Anspruch 1, **dadurch gekennzeichnet, dass** Mittel zum automatischen Anpassen des Kompensationskondensators (7) an die Ruhekapazität des Mikrofonkondensators (1) vorgesehen sind, umfassend
- einen Offset-Filter (5), mit dem der Gleichspannungsanteil des Demodulator-Ausgangssignals ermittelt wird,
- Mitteln zum Überwachen und Auswerten des Gleichspannungsanteils und
- eine Regelungskomponente (6) zum Regeln des Kompensationskondensators (7), so dass der Gleichspannungsanteil des Demodulator-Ausgangssignals minimiert wird.

3. Bauelement nach Anspruch 2, **dadurch gekennzeichnet, dass** die obere Grenzfrequenz des Offset-Filters (5) deutlich kleiner ist als die untere Grenzfrequenz des Mikrofons.

4. Bauelement nach einem der Ansprüche 2 oder 3, **dadurch gekennzeichnet, dass** die Mittel zum Überwachen und Auswerten des Gleichspannungsanteils mindestens einen Fensterkomparator umfassen, mit dem überwacht wird, ob sich der Gleichspannungsanteil innerhalb vorgegebener Grenzen bewegt.

5. Bauelement nach Anspruch 4, **dadurch gekennzeichnet, dass** die Regelungskomponente (6) Mittel zum Initiieren eines elektrischen Resets umfasst.

6. Bauelement nach einem der Ansprüche 1 bis 5, **dadurch gekennzeichnet, dass** der einstellbare Kompensationskondensator (7) in Form einer schaltbaren Kondensatorbank ggf. in Kombination mit einer schaltbaren Widerstandsreihe realisiert ist.

7. Bauelement nach einem der Ansprüche 2 bis 6, **dadurch gekennzeichnet, dass** dem Referenzeingang des Operationsverstärkers (3) mindestens ein regelbarer Referenzkondensator (33) zur Rausch- und Störsignalunterdrückung vorgeschaltet ist, der zusammen mit dem Kompensationskondensator (7) geregelt wird.

8. Verfahren zum Betreiben eines mikromechanischen Mikrofonbauelements mit einer akustisch aktiven Membran, die als auslenkbare Elektrode eines Mikrofonkondensators (1) fungiert, und mit einem feststehenden akustisch durchlässigen Gegenelement, das als Gegenelektrode des Mikrofonkondensators (1) fungiert; **dadurch gekennzeichnet,**
**dass** ein hochfrequentes Taktsignal (2) an den Mikrofonkondensator (1) angelegt wird und das invertierte Taktsignal (2') an einen einstellbaren aber akustisch nicht aktiven Kompensationskondensator (7) angelegt wird, **dass** die Summe des Stromflusses durch den Mikrofonkondensator (1) und des Stromflusses durch den Kompensationskondensator (7) mit Hilfe eines integrierenden Operationsverstärkers (3) aufintegriert wird, und **dass** das Ausgangssignal des integrierenden Operationsverstärkers (3) mit Hilfe eines mit dem Taktsignal (2) synchronisierten Demodulators (4) demoduliert wird und durch eine Tiefpassfilterung des demodulierten Signals ein den Kapazitätsänderungen des Mikrofonkondensators (1) entsprechendes Mikrofonsignal gewonnen wird.

9. Verfahren nach Anspruch 8, **dadurch gekennzeichnet, dass** der Kompensationskondensator (7) automatisch an die Ruhekapazität des Mikrofonkondensators (1) angepasst wird, indem
- der Gleichspannungsanteil des demodulierten Signals ermittelt wird, und
- der Kompensationskondensator (7), so geregelt wird, dass dieser Gleichspannungsanteil minimiert wird.

10. Verfahren nach Anspruch 9, **dadurch gekennzeichnet, dass** der Kompensationskondensator (7) schrittweise, linear und/oder in einem binären Suchalgorithmus angepasst wird.

11. Verfahren nach einem der Ansprüche 9 oder 10, **dadurch gekennzeichnet, dass** die automatische Anpassung des Kompensationskondensators (7) an die Ruhekapazität des Mikrofonkondensators (1) während des Abgleichs bzw. der Initialisierung des Mikrofonbauelements erfolgt.

12. Verfahren nach einem der Ansprüche 8 bis 11, **dadurch gekennzeichnet, dass** der Gleichspannungsanteil des demodulierten Signals während des Mikrofonbetriebs regelmäßig oder kontinuierlich überwacht wird.

13. Verfahren nach Anspruch 12, **dadurch gekennzeichnet, dass**, wenn der Gleichspannungsanteil einen vorgegebenen maximalen Grenzwert Umax übersteigt, ein elektrischer Reset initiiert wird, bei dem der Mikrofonkondensator (1) vollständig entladen wird.

14. Verfahren nach einem der Ansprüche 12 oder 13, **dadurch gekennzeichnet, dass** eine automatische Anpassung des Kompensationskondensators (7) vorgenommen wird, wenn der Gleichspannungsanteil ein durch einen weiteren Grenzwert (UT) vorgegebenes Toleranzband verlässt.

15. Verfahren nach einem der Ansprüche 12 bis 14, **dadurch gekennzeichnet, dass** durch Auswertung des Gleichspannungsanteils des demodulierten Signals Beschleunigungen detektiert werden, die senkrecht zur Membran des Mikrofonkondensators (1) wirken.

## Claims

1. Element having a micromechanical microphone structure, comprising at least
- an acoustically active diaphragm which acts as a deflectable electrode of a microphone capacitor (1),
- a fixed acoustically permeable opposing element which acts as an opposing electrode of the microphone capacitor (1), and
- means for sensing and evaluating the capacitance changes in the microphone capacitor (1);
**characterized by**
- means for applying a high-frequency clock signal (2) to the microphone capacitor (1) and for applying the inverted clock signal (2') to an adjustable but acoustically nonactive compensating capacitor (7),
- an integrating operational amplifier (3) which integrates the sum of the flow of current through the microphone capacitor (1) and of the flow of current through the compensating capacitor (7),
- a demodulator (4), which is in sync with the clock signal (2), for the output signal from the integrating operational amplifier (3), and
- a low-pass filter in order to obtain from the output signal from the demodulator (4) a microphone signal which corresponds to the capacitance changes in the microphone capacitor (1).

2. Element according to Claim 1, **characterized in that** means for automatically matching the compensating capacitor (7) to the quiescent capacitance of the microphone capacitor (1) are provided, comprising
- an offset filter (5) which is used to ascertain the DC voltage component of the demodulator output signal,
- means for monitoring and evaluating the DC voltage component, and
- a regulatory component (6) for regulating the compensating capacitor (7), with the result that the DC voltage component of the demodulator output signal is minimized.

3. Element according to Claim 2, **characterized in that** the upper cut-off frequency of the offset filter (5) is distinctly lower than the lower cut-off frequency of the microphone.

4. Element according to either of Claims 2 and 3, **characterized in that** the means for monitoring and evaluating the DC voltage component comprise at least one window comparator which is used to monitor whether the DC voltage component moves within prescribed limits.

5. Element according to Claim 4, **characterized in that** the regulatory component (6) comprises means for initiating an electrical reset.

6. Element according to one of Claims 1 to 5, **characterized in that** the adjustable compensating capacitor (7) is implemented in the form of a switchable capacitor bank, possibly in combination with a switchable resistor series.

7. Element according to one of Claims 2 to 6, **characterized in that** the reference input of the operational amplifier (3) has at least one regulatable reference capacitor (33) for noise and interference-signal rejection connected upstream of it which is regulated together with the compensating capacitor (7).

8. Method for operating a micromechanical microphone element having an acoustically active diaphragm which acts as a deflectable electrode of a microphone capacitor (1), and having a fixed acoustically permeable opposing element which acts as an opposing electrode of the microphone capacitor (1); **characterized**
**in that** a high-frequency clock signal (2) is applied to the microphone capacitor (1), and the inverted clock signal (2') is applied to an adjustable but acoustically nonactive compensating capacitor (7),
**in that** the sum of the flow of current through the microphone capacitor (1) and of the flow of current through the compensating capacitor (7) is integrated using an integrating operational amplifier (3), and
**in that** the output signal from the integrating operational amplifier (3) is demodulated using a demodulator (4) which is in sync with the clock signal (2), and low-pass filtering of the demodulated signal obtains a microphone signal which corresponds to the capacitance changes in the microphone capacitor (1).

9. Method according to Claim 8, **characterized in that** the compensating capacitor (7) is automatically matched to the quiescent capacitance of the microphone capacitor (1) by virtue of
- the DC voltage component of the demodulated signal being ascertained, and
- the compensating capacitor (7) being regulated such that this DC voltage component is minimized.

10. Method according to Claim 9, **characterized in that** the compensating capacitor (7) is matched in steps, linearly and/or in a binary search algorithm.

11. Method according to either of Claims 9 and 10, **characterized in that** the compensating capacitor (7) is automatically matched to the quiescent capacitance of the microphone capacitor (1) during the alignment or initialization of the microphone element.

12. Method according to one of Claims 8 to 11, **characterized in that** the DC voltage component of the demodulated signal is monitored regularly or continuously during microphone operation.

13. Method according to Claim 12, **characterized in that** if the DC voltage component exceeds a prescribed maximum limit value Uₘₐₓ then an electrical reset is initiated, which involves the microphone capacitor (1) being fully discharged.

14. Method according to either of Claims 12 and 13, **characterized in that** the compensating capacitor (7) is automatically matched when the DC voltage component leaves a tolerance band prescribed by a further limit value (UT).

15. Method according to one of Claims 12 to 14, **characterized in that** evaluation of the DC voltage component of the demodulated signal detects accelerations which are effective perpendicular to the diaphragm of the microphone capacitor (1).

## Revendications

1. Composant ayant une structure de microphone micromécanique, comprenant au moins :
- une membrane acoustiquement active qui fonctionne en tant qu'électrode pouvant être déviée d'un condensateur de microphone (1),
- un contre-élément acoustiquement transparent fixe qui fonctionne en tant que contre-électrode du condensateur de microphone (1), et
- des moyens destinés à détecter et à évaluer les variations de capacité du condensateur de microphone (1) ;
**caractérisé par** :
- des moyens destinés à appliquer un signal d'horloge à haute fréquence (2) au condensateur de microphone (1) et à appliquer le signal d'horloge inversé (2') à un condensateur de compensation (7) réglable mais non acoustiquement actif,
- un amplificateur opérationnel intégrateur (3) qui intègre la somme du courant passant à travers le condensateur de microphone (1) et du courant passant à travers le condensateur de compensation (7),
- un démodulateur (4) synchronisé avec le signal d'horloge (2), destiné au signal de sortie de l'amplificateur opérationnel intégrateur (3), et
- un filtre passe-bas destiné à obtenir à partir du signal de sortie du démodulateur (4) un signal de microphone correspondant aux variations de capacité du condensateur de microphone (1).

2. Composant selon la revendication 1, **caractérisé en ce que** des moyens sont prévus pour adapter automatiquement le condensateur de compensation (7) à la capacité de repos du condensateur de microphone (1), comprenant :
- un filtre à décalage (5) au moyen duquel la composante de tension continue du signal de sortie de démodulateur est déterminée,
- des moyens destinés à surveiller et à évaluer la composante de tension continue, et
- un composant de régulation (6) destiné à réguler le condensateur de compensation (7) de manière à minimiser la composante de tension continue du signal de sortie de démodulateur.

3. Composant selon la revendication 2, **caractérisé en ce que** la fréquence de coupure supérieure du filtre à décalage (5) est beaucoup plus faible que la fréquence de coupure inférieure du microphone.

4. Composant selon l'une quelconque des revendications 2 ou 3, **caractérisé en ce que** les moyens destinés à surveiller et évaluer la composante de tension continue comprennent au moins un comparateur à fenêtre au moyen duquel on surveille si la composante de tension continue se déplace entre des limites prédéterminées.

5. Composant selon la revendication 4, **caractérisé en ce que** le composant de régulation (6) comprend des moyens destinés à déclencher une réinitialisation électrique.

6. Composant selon l'une quelconque des revendications 1 à 5, **caractérisé en ce que** le condensateur de compensation réglable (7) est réalisé sous la forme d'une série de condensateurs commutables, éventuellement en combinaison avec une série de résistances commutables.

7. Composant selon l'une quelconque des revendications 2 à 6, **caractérisé en ce qu'**en amont de l'entrée de référence de l'amplificateur opérationnel (3) est monté au moins un condensateur de référence pouvant être régulé (33) qui est régulé au moyen du condensateur de compensation (7) pour supprimer les signaux de bruit et parasites.

8. Procédé pour faire fonctionner un composant de microphone micromécanique ayant une membrane acoustiquement active qui fonctionne en tant qu'électrode pouvant être déviée d'un condensateur de microphone (1), et ayant un contre-élément acoustiquement transparent fixe qui fonctionne en tant que contre-électrode du condensateur de microphone (1) ; **caractérisé**
**en ce qu'**un signal d'horloge à haute fréquence (2) est appliqué au condensateur de microphone (1) et en ce que le signal d'horloge inversé (2') est appliqué à un condensateur de compensation (7) réglable mais non acoustiquement actif,
**en ce que** la somme du courant passant à travers le condensateur de microphone (1) et du courant passant à travers le condensateur de compensation (7) est intégrée à l'aide d'un amplificateur opérationnel intégrateur (3), et
**en ce que** le signal de sortie de l'amplificateur opérationnel intégrateur (3) est démodulé à l'aide d'un démodulateur (4) synchronisé avec le signal d'horloge (2) et en ce qu'un signal de microphone correspondant aux variations de capacité du condensateur de microphone (1) est obtenu par un filtrage passe-bas du signal démodulé.

9. Procédé selon la revendication 8, **caractérisé en ce que** le condensateur de compensation (7) est automatiquement adapté à la capacité de repos du condensateur de microphone (1)
- en déterminant la composante de tension continue du signal démodulé, et
- en régulant le condensateur de compensation (7) de manière à minimiser cette composante de tension continue.

10. Procédé selon la revendication 9, **caractérisé en ce que** le condensateur de compensation (7) est adapté pas à pas, linéairement et/ou par un algorithme de recherche binaire.

11. Procédé selon l'une quelconque des revendications 9 ou 10, **caractérisé en ce que** l'adaptation automatique du condensateur de compensation (7) à la capacité de repos du condensateur de microphone (1) s'effectue pendant l'étalonnage ou l'initialisation du composant de microphone.

12. Procédé selon l'une quelconque des revendications 8 à 11, **caractérisé en ce que** la composante de tension continue du signal démodulé est surveillée régulièrement ou en continu pendant le fonctionnement du microphone.

13. Procédé selon la revendication 12, **caractérisé en ce que**, lorsque la composante de tension continue dépasse une valeur limite maximale prédéterminée Umax, une réinitialisation électrique est déclenchée, lors de laquelle le condensateur de microphone (1) est entièrement déchargé.

14. Procédé selon l'une quelconque des revendications 12 ou 13, **caractérisé en ce qu'**une adaptation automatique du condensateur de compensation (7) est effectuée lorsque la composante de tension continue sort d'une de bande de tolérance prédéterminée en franchissant une autre valeur de seuil (UT).

15. Procédé selon l'une quelconque des revendications 12 à 14, **caractérisé en ce qu'**on détecte, par évaluation de la composante de tension continue du signal démodulé, des accélérations qui agissent perpendiculairement à la membrane du condensateur de microphone (1).
